# EUROPÄISCHE PATENTSCHRIFT

(11) **EP 3 977 496 B1**
(45) Veröffentlichungstag und Bekanntmachung des Hinweises auf die Patenterteilung: **03.07.2024**
(21) Anmeldenummer: 20727196.6
(22) Anmeldetag: 15.05.2020
(51) Int. Cl.: H01H 47/00

(54) **VERFAHREN ZUR AUSFALLVORHERSAGE VON ELEMENTARRELAIS**
METHOD FOR PREDICTING THE FAILURE OF ELEMENTARY RELAYS
PROCÉDÉ DE PRÉDICTION DE DÉFAILLANCE D'UN RELAIS ÉLÉMENTAIRE

(30) Priorität: 28.05.2019 DE 102019114208
(43) Veröffentlichungstag der Anmeldung: 06.04.2022
(73) Patentinhaber: Phoenix Contact GmbH & Co. KG, 32825 Blomberg (DE)
(72) Erfinder: HEINRICH, Sebastian, 12489 Berlin (DE)
(74) Vertreter: Patentship Patentanwaltsgesellschaft mbH
(86) Internationale Anmeldenummer: PCT/EP2020/063589
(87) Internationale Veröffentlichungsnummer: WO 2020/239471

(56) Entgegenhaltungen:
- WO-A1-2013/137971
- WO-A1-2013/189527
- CN-A- 107 656 200

## Beschreibung

Die Erfindung betrifft ein Verfahren zur Ausfallvorhersage von Elementarrelais und eine Vorrichtung zum Überwachen eines Elementarrelais.

Die Zuverlässigkeit von Elementarrelais wird über Labortests nach DIN EN 61810-2-1 abgeschätzt. Kennzahl ist die Schaltspielzahl, bei welcher 10% der getesteten Relais ausgefallen sind ("B10-Wert"). Diese Tests werden für typischerweise je drei Normlasten AC und DC durchgeführt. Da nicht bekannt ist, bei welcher Last ein Betreiber das Relais einsetzt, wird der kleinste bestimmte "B10-Wert" angenommen. Auf Anfrage erhalten Kunden oft auch direkt die bestimmten "B10-Werte". Mithilfe dieses "B10-Wertes" ist keine Ausfallvorhersage für ein bestimmtes Relais und einen konkreten Anwendungsfall möglich. Der Betreiber des Relais kann sich an der Schaltspielzahl orientieren und alle Relais vorzeitig austauschen. Damit werden unnötig viele Schaltspiele verschenkt und es kommt weiterhin zu Frühausfällen.

Das Dokument WO 2013/137971 A1 offenbart ein Relais mit einem ersten und zweiten Anschluss, einem dritten und vierten Anschluss und trennbaren Kontakten, welche elektrisch verbunden sind zwischen dem ersten und dem zweiten Anschluss.

Das Dokument CN 107 656 200 A offenbart ein Gerät und ein Verfahren zum Abschätzen einer Dienstlebensdauer eines Batterierelais.

Das Dokument WO 2013 / 189527 A1 offenbart eine Schaltanordnung mit einem elektromagnetischen Relais, das eine Relaisspule, Relaiskontakte und einen mit den Relaiskontakten in Wirkverbindung stehenden Relaisanker aufweist.

Die Erfindung hat es zur Aufgabe, den Ausfall eines Elementarrelais besser vorherzusagen. Insbesondere ist es die Aufgabe der Erfindung, eine Technik zu schaffen, mit der Ausfälle von Elementarrelais rechtzeitig erkannt werden können, so dass der Betreiber notwendige Maßnahmen einleiten kann, z.B. einen Austausch des/der betroffenen Relais.

Diese Aufgabe wird durch die Gegenstände mit den Merkmalen nach den unabhängigen Ansprüchen gelöst. Vorteilhafte Ausführungsformen sind Gegenstand der abhängigen Ansprüche, der Beschreibung und der Zeichnungen.

Die Erfindung basiert auf der Idee, einen Kontaktspannungsabfall beim Einschalten des Lastkontaktes aufzuzeichnen und ein charakteristisches Merkmal in diesem Signalverlauf zu überwachen. Als vorteilhaft für ein solches charakteristisches Merkmal hat sich das Kontaktspannungsrauschen bzw. eine Rauschlänge des Kontaktspannungsrauschens herausgestellt.

Ein Relais bzw. Elementarrelais, wie in dieser Anmeldung beschrieben, ist ein durch elektrischen Strom betriebener, elektromagnetisch wirkender, fernbetätigter Schalter mit in der Regel zwei Schaltstellungen. Das Relais wird über einen Steuerstromkreis aktiviert und kann weitere Stromkreise schalten.

Gemäß einem ersten Aspekt wird die oben dargestellte Aufgabe gelöst durch ein Verfahren zur Ausfallvorhersage eines Elementarrelais mit einem Schalter zum Schalten eines Lastkontaktes eines Laststromkreises und einer Erregerspule zum Betätigen des Schalters, wobei das Verfahren die folgenden Schritte umfasst: Erregen der Erregerspule zum Einschalten des Lastkontaktes; Erfassen eines zeitlichen Verlaufs einer Kontaktspannung an dem Lastkontakt beim Einschalten des Lastkontaktes; Extrahieren eines charakteristischen Merkmals aus dem zeitlichen Verlauf der Kontaktspannung; und Überwachen des charakteristischen Merkmals.

Damit wird der technische Vorteil erreicht, dass der Ausfall des Elementarrelais besser vorhergesagt werden kann. Die Kontaktspannung am Lastkontakt ist ein guter Indikator für eine Ausfallvorhersage des Elementarrelais.

Mit dem charakteristischen Merkmal kann dann das Elementarrelais während des Betriebs des Elementarrelais überwacht werden. Die Rauschlänge kann plötzlich, also über einen Zeitraum von beispielsweise größer 1000 bis 10000 Schaltspielen stark ansteigen, so dass mit einem bevorstehenden Ausfall zu rechnen ist. Daher sollte während des gesamten Betriebs die Kontaktspannung überprüft werden. Zum Erkennen reicht aber eine zyklische Messung alle N Schaltspiele (SSp) oder eine Mittelung über N Schaltspiele aus. Die Ausfallvorhersage kann hier binär verstanden werden, d.h. Rauschen ergibt Ausfall; kein Rauschen ergibt keinen rauschbedingten Ausfall.

Das Verfahren stellt damit dem Relaisbetreiber eine geeignete Technik zur Verfügung, mit der er Ausfälle von Elementarrelais rechtzeitig erkennen kann, um rechtzeitig notwendige Maßnahmen einleiten kann, z.B. einen Austausch des/der betroffenen Relais.

Als Schaltspiel oder Schaltzyklus wird der vollständige Wechsel eines Schaltzustandes bei einem elektrischen Schalter zurück zur Ausgangsstellung bezeichnet: von der Stellung *Aus* auf *Ein* zurück auf *Aus* bzw. von *Ein* auf *Aus* zurück auf *Ein.*

Ein Ausfall bedeutet, dass kein zuverlässiges Verbinden oder Trennen der Schaltkontakte möglich ist, bedingt durch einen Kontaktverschleiß.

Gemäß dem erfinderischen Verfahren umfasst das charakteristische Merkmal ein Kontaktspannungsrauschen an dem Lastkontakt beim Einschaltvorgang des Elementarrelais.

Das Kontaktspannungsrauschen am Lastkontakt ist eine geeignete Bezugsgröße, um auf einen bevorstehenden Ausfall zu schließen. Die Ausfallvorhersage kann hier binär verstanden werden, d.h. Rauschen heißt Ausfall; kein Rauschen heißt kein rauschbedingter Ausfall.

In einer vorteilhaften Ausführungsform des Verfahrens umfasst das Extrahieren des Kontaktspannungsrauschens ein Bestimmen einer Abweichung des erfassten Kontaktspannungsverlaufs zu einer vorgegebenen Referenzkurve.

Damit wird der technische Vorteil erreicht, dass sich der Verlauf des Kontaktspannungsrauschens einfach und effizient bestimmen lässt. Als Abweichung kann hier zum Beispiel eine Abweichung des Betrags der Amplituden des Kontaktspannungsrauschens zu der Referenzkurve verwendet werden oder eine quadratische oder andersartig gewichtete Abweichung, welche das Rauschen effizient bewertet.

In einer vorteilhaften Ausführungsform des Verfahrens stellt die Referenzkurve den zeitlichen Verlauf der Kontaktspannung an dem Lastkontakt eines neu hergestellten Elementarrelais dar.

Damit wird der technische Vorteil erreicht, dass sich die Referenz auf den ursprünglichen Spannungsverlauf eines fabrikneuen Relais beim Einschaltvorgang des Relais bezieht und Abweichungen zu diesem ursprünglichen Verlauf effizient bestimmt werden können.

In einer vorteilhaften Ausführungsform des Verfahrens zeigt die Referenzkurve einen monoton fallenden Spannungsverlauf von einer Anfangsspannung zu einer Endspannung an.

Damit wird der technische Vorteil erreicht, dass die Referenzkurve den idealen Schaltvorgang von Laststromkreis "aus" zu Laststromkreis "an" angibt, d.h. den Schaltvorgang eines fabrikneuen Relais. Diese Referenzkurve entspricht einer an den Ecken abgeflachten Stufenfunktion, wobei die Abflachung aufgrund der Schaltkapazitäten und -induktivitäten der nicht-idealen Schaltelemente zustande kommt.

In einer vorteilhaften Ausführungsform des Verfahrens umfasst das Verfahren ferner: Überwachen einer Amplitude des Kontaktspannungsrauschens während des Betriebs des Elementarrelais.

Damit wird der technische Vorteil erreicht, dass das Relais in Bezug auf einen möglichen bevorstehenden Ausfall effizient überwacht werden kann. Mit der Amplitude des Kontaktspannungsrauschens lassen sich geeignete Aussagen zum bevorstehenden Ausfall des Relais machen.

In einer vorteilhaften Ausführungsform des Verfahrens umfasst das Verfahren ferner: Überwachen einer Rauschlänge des Kontaktspannungsrauschens über dem Lastkontakt während des Betriebs des Elementarrelais.

Damit wird der technische Vorteil erreicht, dass das Relais in Bezug auf einen möglichen bevorstehenden Ausfall effizient überwacht werden kann. Mit der Rauschlänge bzw. Dauer des Kontaktspannungsrauschens lassen sich geeignete Aussagen zum bevorstehenden Ausfall des Relais machen.

In einer vorteilhaften Ausführungsform des Verfahrens umfasst das Verfahren ferner: Überwachen einer zeitlichen Veränderung des Kontaktspannungsrauschens über dem Lastkontakt bezüglich einer Anzahl von Schaltspielen des Elementarrelais.

Damit wird der technische Vorteil erreicht, dass das Relais in Bezug auf einen möglichen bevorstehenden Ausfall effizient überwacht werden kann. Mit einer Überwachung der zeitlichen Veränderung des Kontaktspannungsrauschens lassen sich geeignete Aussagen zu einem möglichen Ausfall des Relais machen.

In einer vorteilhaften Ausführungsform des Verfahrens umfasst das Verfahren ferner: Bestimmen einer Ausfallvorhersage des Elementarrelais basierend auf einer über die vorgegebene Anzahl von Schaltspielen gemittelten Rauschlänge.

Damit wird der technische Vorteil erreicht, dass zum Erkennen eines bevorstehenden Ausfalls nicht jedes Schaltspiel überprüft werden muss. Es reicht vielmehr eine zyklische Messung alle N Schaltspiele oder eine Mittelung über N Schaltspiele aus. Damit reduziert sich der Rechenaufwand bzw. Überwachungsaufwand des Verfahrens.

In einer vorteilhaften Ausführungsform des Verfahrens umfasst das Verfahren ferner: Ausgeben eines Warnhinweises bei Überschreiten eines vorgegebenen Grenzwertes für die gemittelte Rauschlänge.

Damit wird der technische Vorteil erreicht, dass auf einfache Art ein zuverlässiger Indikator für einen unmittelbar bevorstehenden Ausfall des Relais angegeben werden kann und der Warnhinweis, z.B. ein Alarmsignal, den Betreiber des Relais darauf aufmerksam macht, dass das Relais ausgewechselt werden sollte.

Gemäß einem zweiten Aspekt wird die oben dargestellte Aufgabe gelöst durch eine Vorrichtung zur Überwachung eines Elementarrelais mit einem Schalter zum Schalten eines Lastkontaktes eines Laststromkreises und einer Erregerspule zum Betätigen des Schalters, wobei die Vorrichtung folgendes umfasst: eine Steuerung, die ausgebildet ist, die Erregerspule zum Einschalten des Lastkontaktes zu erregen; eine Erfassungseinrichtung zum Erfassen eines zeitlichen Verlaufs einer Kontaktspannung an dem Lastkontakt beim Einschalten des Lastkontaktes durch die Steuerung; eine Auswertungseinrichtung zum Extrahieren eines charakteristischen Merkmals aus dem zeitlichen Verlauf der Kontaktspannung; und eine Überwachungseinrichtung zum Überwachen des charakteristischen Merkmals über eine Anzahl von Schaltspielen des Elementarrelais.

Damit wird der technische Vorteil erreicht, dass mit einer solchen Vorrichtung ein Elementarrelais effizient überwacht werden kann und ein Ausfall des Elementarrelais besser vorhergesagt werden kann. Wie bereits oben erwähnt, stellt die Kontaktspannung am Lastkontakt einen guten Indikator für einen bevorstehenden Ausfall des Elementarrelais dar.

Mit dem charakteristischen Merkmal kann die Überwachungseinrichtung das Elementarrelais während des Betriebs des Elementarrelais überwachen. Die Rauschlänge kann plötzlich, also über einen Zeitraum von beispielsweise größer 1000 bis 10000 Schaltspielen stark ansteigen, so dass mit einem bevorstehenden Ausfall zu rechnen ist. Daher sollte während des gesamten Betriebs die Kontaktspannung überprüft werden. Zum Erkennen reicht aber eine zyklische Messung alle N Schaltspiele (SSp) oder eine Mittelung über N Schaltspiele aus. Die Ausfallvorhersage kann hier binär verstanden werden, d.h. Rauschen ergibt Ausfall; kein Rauschen ergibt keinen rauschbedingten Ausfall.

Die Überwachungsvorrichtung stellt damit dem Relaisbetreiber eine geeignete Technik zur Verfügung, mit der er Ausfälle von Elementarrelais rechtzeitig erkennen kann, um rechtzeitig notwendige Maßnahmen einleiten kann, z.B. einen Austausch des/der betroffenen Relais.

Gemäß der erfinderischen Vorrichtung umfasst das charakteristische Merkmal ein Kontaktspannungsrauschen an dem Lastkontakt beim Einschaltvorgang des Elementarrelais.

Das Kontaktspannungsrauschen am Lastkontakt ist eine geeignete Bezugsgröße, um auf einen möglichen bevorstehenden Ausfall des Relais zu schließen. Die Ausfallvorhersage kann hier binär verstanden werden, d.h. Rauschen heißt Ausfall; kein Rauschen heißt kein rauschbedingter Ausfall.

In einer vorteilhaften Ausführungsform der Vorrichtung ist die Erfassungseinrichtung ausgebildet, den zeitlichen Verlauf der Kontaktspannung an dem Lastkontakt für eine Signaldauer von etwa 20 bis 50 ms nach dem Erregen der Erregerspule durch die Steuerung aufzuzeichnen.

Damit wird der technische Vorteil erreicht, dass die Erfassungseinrichtung den Spannungsübergang am Lastkontakt von Relaiskontakt offen zu Relaiskontakt geschlossen in geeigneter Weise aufzeichnen kann, so dass die relevanten Zeiten, zu denen Änderungsvorgänge auftreten aufgezeichnet sind und ausgewertet werden können. Je nach Relaistyp sind das eine Signaldauer von etwa 20 bis 50 Millisekunden. Es kann natürlich aber auch länger aufgezeichnet werden.

In einer vorteilhaften Ausführungsform der Vorrichtung ist die Auswertungseinrichtung ausgebildet, eine Rauschlänge des Kontaktspannungsrauschens während des Betriebs des Elementarrelais zu bestimmen; und die Überwachungseinrichtung ist ausgebildet, eine Ausfallvorhersage des Elementarrelais basierend auf einer über die vorgegebene Anzahl von Schaltspielen gemittelten Rauschlänge zu ermitteln.

Damit wird der technische Vorteil erreicht, dass schnell erkannt werden kann, wenn die Rauschlänge plötzlich stark ansteigt, was auf einen bevorstehenden Ausfall hindeutet.

Weitere Ausführungsbeispiele werden Bezug nehmend auf die beiliegenden Zeichnungen erläutert. Es zeigen:
- Fig. 1: eine Schaltplandarstellung eines Elementarrelais 100 mit einem Wechselkontakt;
- Fig. 2: eine schematische Darstellung eines Verfahrens 200 zur Ausfallvorhersage eines Elementarrelais 100 gemäß einer Ausführungsform;
- Fig. 3: einen beispielhaften zeitlichen Verlauf des Kontaktrauschens 300 am Lastkontakt des Elementarrelais 100 am Anfang 301 und Ende 302 der Lebensdauer des Elementarrelais 100;
- Fig. 4: einen beispielhaften Verlauf der Kontaktrauschlänge 400 über eine Lebensdauer des Elementarrelais 100; und
- Fig. 5: eine schematische Darstellung einer Vorrichtung 500 zur Überwachung eines Elementarrelais 100 gemäß einer Ausführungsform.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne vom Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen.

Es werden Vorrichtungen beschrieben, und es werden Verfahren beschrieben. Es versteht sich, dass Grundeigenschaften der Vorrichtungen auch für die Verfahren gelten und umgekehrt. Deshalb wird der Kürze halber gegebenenfalls auf eine doppelte Beschreibung solcher Eigenschaften verzichtet.

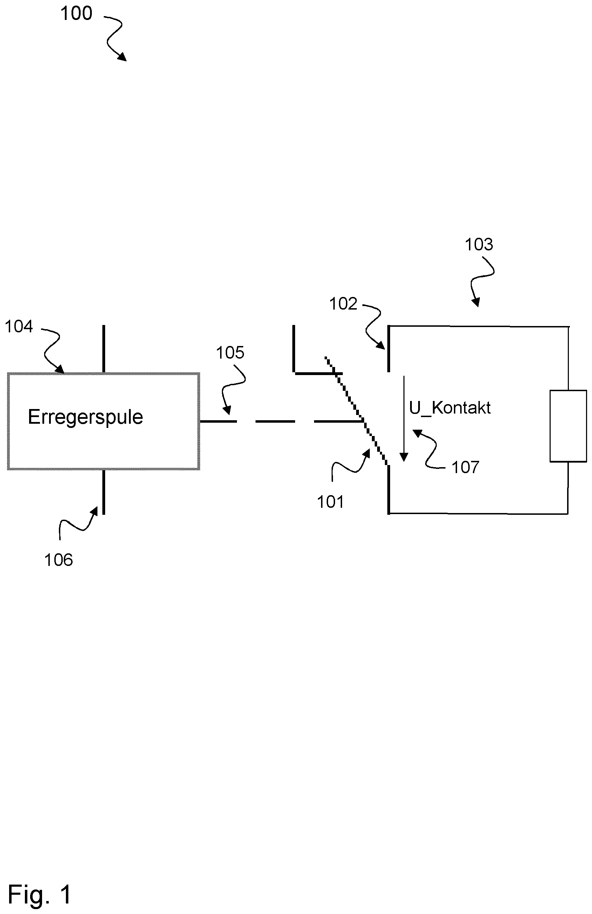

Fig. 1 zeigt eine Schaltplandarstellung eines Elementarrelais 100 mit einem Wechselkontakt bzw. Lastkontakt 102. Das Elementarrelais 100 umfasst einen Schalter 101 zum Schalten eines Lastkontaktes 102 eines Laststromkreises 103 und eine Erregerspule 104 zum Betätigen 105 des Schalters 101. Die Erregerspule 104 kann z.B. durch Anlegen einer Spannung an den beiden Kontakten 106 der Spule 104 erregt bzw. aktiviert werden. Dann entsteht ein Magnetfeld, durch das eine Kraft auf den Schalter 101 ausgeübt wird, so dass der Lastkontakt 102 geschaltet und damit der Laststromkreis 103 eingeschaltet wird. Die Krafteinwirkung kann beispielsweise über einen Anker (nicht dargestellt) erfolgen. Wird die Spannung von den beiden Kontakten 106 der Spule 104 weggeschaltet bzw. deaktiviert, so kehrt der Schalter 101 wieder in seine Ausgangsposition (gemäß der Darstellung in Fig. 1) zurück und der Lastkontakt 102 ist ausgeschaltet und damit auch der Laststromkreis 103. Beim Einschaltvorgang wird die Kontaktspannung 107 am Lastkontakt 102 abgebaut, d.h. sie geht über von einer Leerlaufspannung zu einer Kurzschlussspannung gegen Null. Der genaue Übergang der Kontaktspannung 107 ist Gegenstand dieser Anmeldung und wird in den folgenden Abschnitten näher beschrieben.

Das Elementarrelais 100 kann beispielsweise als mechanisches Relais ausgeführt sein. Das mechanische Relais arbeitet meist nach dem Prinzip des Elektromagneten. Ein Strom in der Erregerspule erzeugt einen magnetischen Fluss durch den ferromagnetischen Kern und einen daran befindlichen, beweglich gelagerten, ebenfalls ferromagnetischen Anker. An einem Luftspalt kommt es zur Krafteinwirkung auf den Anker, wodurch dieser einen oder mehrere Kontakte schaltet. Der Anker wird durch Federkraft in die Ausgangslage zurückversetzt, sobald die Spule nicht mehr erregt ist.

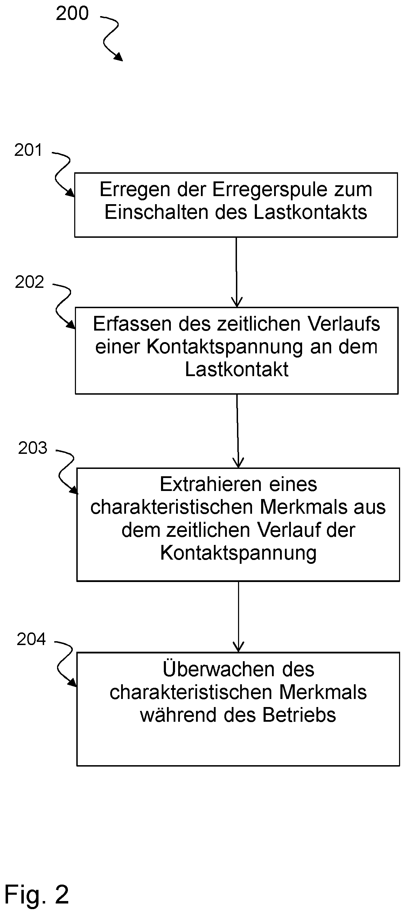

Fig. 2 zeigt eine schematische Darstellung eines Verfahrens 200 zur Ausfallvorhersage eines Elementarrelais 100 gemäß einer Ausführungsform. Das Elementarrelais ist beispielsweise ein Elementarrelais 100 wie in Figur 1 beschrieben. D.h. es umfasst einen Schalter 101 zum Schalten eines Lastkontaktes 102 eines Laststromkreises 103 und eine Erregerspule 104 zum Betätigen 105 des Schalters 101.

Das Verfahren 200 umfasst die folgenden Schritte: Erregen 201 der Erregerspule 104 zum Einschalten 105 des Lastkontaktes 102; Erfassen 202 eines zeitlichen Verlaufs einer Kontaktspannung 107 an dem Lastkontakt 102 beim Einschalten 105 des Lastkontaktes 102; Extrahieren 203 eines charakteristischen Merkmals aus dem zeitlichen Verlauf der Kontaktspannung 107; und Überwachen 204 des charakteristischen Merkmals über eine Anzahl von Schaltspielen des Elementarrelais 100.

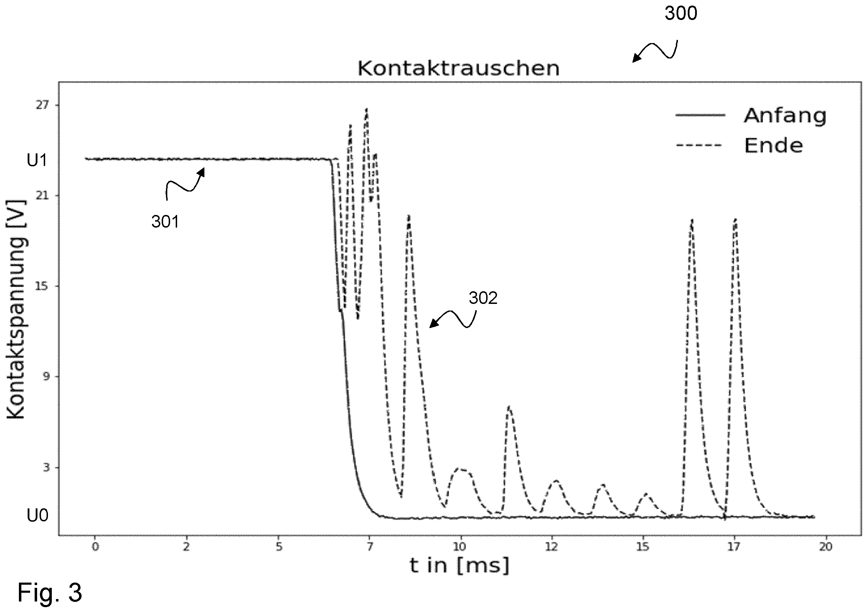

Das charakteristische Merkmal ist erfindungsgemäß ein Kontaktspannungsrauschen am Lastkontakt 102 beim Einschaltvorgang 105 des Elementarrelais 100 umfassen, z.B. ein Kontaktspannungsrauschen 300, wie in Figur 3 dargestellt.

In einem Ausführungsbeispiel kann das Extrahieren des Kontaktspannungsrauschens ein Bestimmen einer Abweichung des erfassten Kontaktspannungsverlaufs 302 zu einer vorgegebenen Referenzkurve 301 umfassen, z.B. entsprechend der Darstellung in Fig. 3. Die Referenzkurve 301 kann den zeitlichen Verlauf der Kontaktspannung 107 an dem Lastkontakt 103 eines neu hergestellten Elementarrelais 100 darstellen. Zum Beispiel kann die Referenzkurve 301 einen monoton fallenden Spannungsverlauf von einer Anfangsspannung U1 bzw. Leerlaufspannung des Laststromkreises 103 zu einer Endspannung U0 bzw. Kurzschlussspannung des Laststromkreises 103 anzeigen.

In einem Ausführungsbeispiel kann das Verfahren 200 ein Überwachen einer Amplitude des Kontaktspannungsrauschens über eine Anzahl von Schaltspielen des Elementarrelais 100 umfassen.

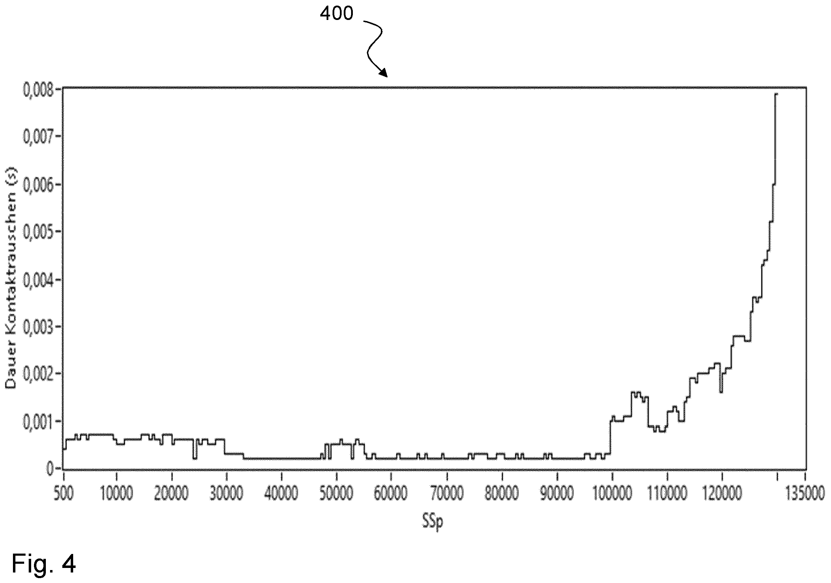

In einem Ausführungsbeispiel kann das Verfahren 200 ein Überwachen einer Rauschlänge bzw. Rauschdauer des Kontaktspannungsrauschens über dem Lastkontakt 102 während des Betriebs des Elementarrelais 100 umfassen, z.B. eine Rauschlänge 400 wie in Figur 4 dargestellt.

In einem Ausführungsbeispiel kann das Verfahren 200 ein Überwachen einer zeitlichen Veränderung des Kontaktspannungsrauschens über dem Lastkontakt 102 während des Betriebs des Elementarrelais 100 umfassen. Wenn sich das Kontaktspannungsrauschen verändert, d.h. stärker wird, ist mit einem bevorstehenden Ausfall zu rechnen. Eine Überwachung einer solchen Veränderung stellt ein geeignetes Maß dar, um eine Vorhersage über eine genaue Ausfallwahrscheinlichkeit machen zu können.

In einem Ausführungsbeispiel kann das Verfahren 200 die folgenden Schritte umfassen: Bestimmen einer Rauschlänge (z.B. entsprechend siehe Figur 4) des Kontaktspannungsrauschens während des Betriebs; und Bestimmen einer Ausfallvorhersage des Elementarrelais 100 basierend auf einer über die vorgegebene Anzahl von Schaltspielen gemittelten Rauschlänge. Bei einer Mittelung der Rauschlänge über die Schaltspiele, d.h. bei einer Mittelung über die pro Schaltspiel aufgezeichneten Rauschlängen, kann eine Veränderung des Rauschens erfasst werden und damit eine Ausfallvorhersage getroffen werden.

In einem Ausführungsbeispiel kann die vorgegebene Anzahl von Schaltspielen eine vorgegebene Anzahl aufeinanderfolgender Einschaltvorgänge 105 umfassen. Alternativ kann auch jedes n-te Schaltspiel herangezogen werden, z.B. n=2, 3, 4, 5, 10, 20, 30, 40, 50, 100, 200, 300, 400, 500, 1000, 2000, 5000, 10000, etc.

In einem Ausführungsbeispiel kann das Verfahren 200 das Ausgeben eines Warnhinweises bei Überschreiten eines vorgegebenen Grenzwertes für die gemittelte Rauschlänge umfassen. Zum Beispiel kann ein Alarmsignal angezeigt werden, z.B. eine rote LED für bevorstehenden Ausfall oder eine grüne LED für unkritischen Zustand.

Im Folgenden wird ein weiteres Ausführungsbeispiel eines Verfahrens 200 zur Ausfallvorhersage eines Elementarrelais 100 beschrieben. Bei diesem Ausführungsbeispiel basiert die Ausfallvorhersage auf dem "Kontaktspannungsrauschen", d.h. einem Rauschen der Spannung am Lastkontakt 102 beim Einschaltvorgang.

Um dieses Merkmal zu erkennen, wird der Kontaktspannungsabfall über dem Lastkontakt 102 des Elementarrelais 100 bei Schließvorgang aufgezeichnet, z.B. entsprechend einer Signaldauer von 20 bis 50 Millisekunden nach Einschalten der Spule 104 je nach Relaistyp.

Bei einem neuen (Relais-) Kontakt ist der Übergang von hoher Kontaktspannung (Kontakt offen) zu kleiner Kontaktspannung nahe 0V (Kontakt geschlossen) schnell, d.h. ohne Rauschen. Bei einem verbrauchten Kontakt verändert sich dieser Übergang: die Spannung macht mehrere Sprünge, d.h. das Signal rauscht, bevor sie bei der Spannung nahe 0V verbleibt, wie in Figur 3 näher dargestellt.

Die Rauschlänge, d.h. die Dauer vom Zeitpunkt der ersten Kontaktspannungsveränderung nach Einschalten der Spule 104 bis zum endgültigen Verbleiben nahe 0V, ist ein Merkmal, welches einen bevorstehenden Ausfall anzeigt. Figur 4 zeigt einen typischen Verlauf der Rauschlänge während der Lebensdauer eines Relais bis zum Ausfall. Dieser wird durch den starken Anstieg der Kurve vorhersagbar.

Für eine Ausfallvorhersage basierend auf diesem Merkmal ist die Rauschlänge zu jedem n-ten Schaltspiel zu bestimmen (z.B. n=100). Das Verfahren zur Bestimmung spielt für die Anwendung keine Rolle. Es hat sich als praktisch erwiesen, die Spannungssignale mehrerer aufeinanderfolgender Einschaltvorgänge zu mitteln und anschließend die Rauschlänge zu bestimmen.

Überschreitet die (gemittelte) Rauschlänge einen vorher in Laborversuchen festgelegten Grenzwert, so ist dies das Signal für einen bevorstehenden Ausfall.

Bis auf den Grenzwert müssen keine Werte gespeichert werden.

Fig. 3 zeigt einen beispielhaften zeitlichen Verlauf des Kontaktrauschens 300 am Lastkontakt des Elementarrelais 100 am Anfang 301 und Ende 302 der Lebensdauer des Elementarrelais 100. Die Kurve 301 stellt den Spannungsübergang der Kontaktspannung am Lastkontakt für ein neues Relais dar, d.h. eine Aufzeichnung am Beginn der Lebensdauer des Relais 100. Die Kurve 302 stellt den Spannungsübergang der Kontaktspannung am Lastkontakt für ein älteres bzw. gealtertes Relais dar, d.h. eine Aufzeichnung am Beginn der Lebensdauer des Relais 100. Wie bereits erwähnt bezeichnet die Lebensdauer die Anzahl an Schaltzyklen oder Schaltspielen, welche mit dem Relais bereits durchgeführt wurden.

Die Kurve 301 ist näherungsweise eine Stufenfunktion mit abgeschrägten Kanten und stellt den Übergang der Leerlaufspannung U1 zur Kurzschlussspannung U0 am Lastkontakt des Laststromkreises dar. Der Lastkontakt ist hier noch eben und zeigt keine Risse oder Brüche aufgrund der Abnutzung durch zahlreiche Schaltvorgänge auf, so dass die Spannung hier sehr schnell von der Leerlaufspannung U1 zur Kurzschlussspannung U0 übergeht. Die Kurve 301 ist monoton fallend. Der Übergang von U1 auf U0 erfolgt hier innerhalb von etwa ein bis zwei Millisekunden.

Bei der Kurve 302 ist der Stufenverlauf kaum mehr erkennbar aufgrund des starken Rauschens, das dem Spannungsübergang überlagert ist. Der Übergang von U1 nach U0 ist unstetig und erfolgt unter zahlreichen Rücksetzern bzw. Rauschen, welche die Alterungsprozesse des Relais anzeigen. Sogar nach etwa 10 Millisekunden nach dem Einschalten des Relais gibt es noch zwei Rücksetzer, die annähernd bis zur Ausgangsspannung U1 reichen.

Fig. 4 zeigt einen beispielhaften Verlauf der Kontaktrauschlänge 400 über eine Lebensdauer des Elementarrelais 100. Die Lebensdauer ist in Anzahl Schaltspielen (SSp) angegeben. Dabei wurde jeweils gemessen, wie lange es dauert bis die Kontaktspannung am Lastkontakt 102 von U1 nach U0 übergegangen ist und der jeweilige Wert über die Anzahl Schaltspiele aufgetragen. Zum Beispiel kann gemessen werden wie lange es dauert bis sich die Kontaktspannung einem vorgegebenen Schwellwert um den Endwert U0 der Kontaktspannung herum annähert.

Ab einer gewissen Anzahl von Schaltspielen, die bei jedem Typ von Relais unterschiedlich sein kann, kann sich die Rauschlänge plötzlich erhöhen, so dass mit einem baldigen Ausfall des Relais gerechnet werden kann. Bei dem Elementarrelais aus Figur 4 passiert dies bei einem Wert von etwa 100.000 Schaltspielen. Bis zu diesem Wert liegt die Rauschlänge unterhalb von 0,001; danach erhöht sich die Rauschlänge und steigt ab einer Anzahl von etwa 130.000 Schaltspielen rapide an, so dass mit einem bevorstehenden Ausfall des Relais zu rechnen ist. Ein Warnhinweis kann beispielsweise gegeben werden, wenn die Dauer des Kontaktrauschens eine erste Schwelle von z.B. 0,001 übersteigt. Ein zweiter Warnhinweis oder ein Alarm können beispielsweise dann angezeigt werden, wenn die Dauer des Kontaktrauschens eine zweite Schwelle von z.B. 0,006 überschreitet. Natürlich können weitere Schwellen gesetzt werden, die weitere Zustände anzeigen.

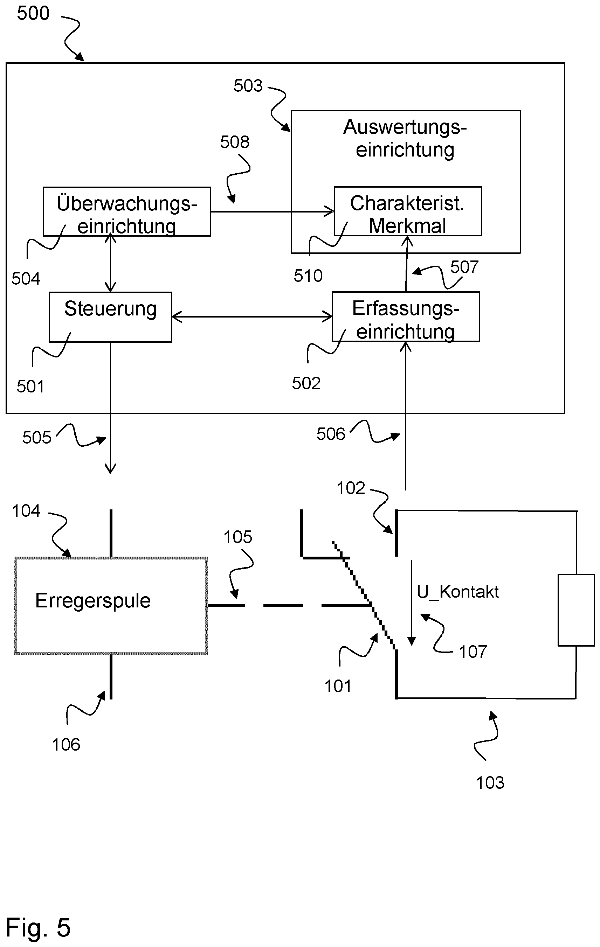

Fig. 5 zeigt eine schematische Darstellung einer Vorrichtung 500 zur Überwachung eines Elementarrelais 100 gemäß einer Ausführungsform. Das Elementarrelais ist beispielsweise ein Elementarrelais 100 wie in Figur 1 beschrieben. D.h. es umfasst einen Schalter 101 zum Schalten eines Lastkontaktes 102 eines Laststromkreises 103 und eine Erregerspule 104 zum Betätigen 105 des Schalters 101.

Die Vorrichtung 500 umfasst eine Steuerung 501, die ausgebildet ist, die Erregerspule 104 zum Einschalten 105 des Lastkontaktes 102 zu erregen 505. Alternativ kann die Steuerung 501 eine Erregung der Spule 104 erkennen, z.B. wenn die Erregung von einem externen Gerät durchgeführt wird.

Die Vorrichtung 500 umfasst eine Erfassungseinrichtung 502 zum Erfassen 506 eines zeitlichen Verlaufs einer Kontaktspannung 107 an dem Lastkontakt 102 beim Einschalten 105 des Lastkontaktes 102 durch die Steuerung 501.

Die Vorrichtung 500 umfasst eine Auswertungseinrichtung 503 zum Extrahieren 507 eines charakteristischen Merkmals 510 aus dem zeitlichen Verlauf der Kontaktspannung 107, z.B. wie oben zu dem Verfahren 200 gemäß Figur 2 beschrieben.

Die Vorrichtung 500 umfasst ferner eine Überwachungseinrichtung 504 zum Überwachen 508 des charakteristischen Merkmals 510 während des Betriebs des Elementarrelais 100.

Das charakteristische Merkmal 510 ist erfindungsgemäß ein Kontaktspannungsrauschen an dem Lastkontakt 102 beim Einschaltvorgang 105 des Elementarrelais 100 umfassen, z.B. ein Kontaktspannungsrauschen 300 wie in Figur 3 dargestellt.

In einem Ausführungsbeispiel der Vorrichtung 500 kann die Erfassungseinrichtung 502 ausgebildet sein, den zeitlichen Verlauf der Kontaktspannung 107 an dem Lastkontakt 102 für eine Signaldauer von etwa 20 bis 50 ms nach dem Erregen 510 der Erregerspule 104 durch die Steuerung 501 aufzuzeichnen 506.

In einem Ausführungsbeispiel der Vorrichtung 500 kann die Auswertungseinrichtung 503 ausgebildet sein, eine Rauschlänge des Kontaktspannungsrauschens (z.B. entsprechend der Darstellung in Fig. 4) während des Betriebs zu bestimmen. Die Überwachungseinrichtung 504 kann ausgebildet sein, eine Ausfallvorhersage des Elementarrelais 100 basierend auf einer über die vorgegebene Anzahl von Schaltspielen gemittelten Rauschlänge zu ermitteln.

Die Erfassungseinrichtung 502 kann z.B. als ein Speicher implementiert sein, in dem die jeweiligen Kontaktspannungsverläufe aufgezeichnet werden. Die Auswertungseinrichtung 503 und die Überwachungseinrichtung 504 können als Prozessor oder Controller implementiert sein, z.B. zusammen mit der Steuerung 501 auf einem Prozessor oder Chip. Alternativ kann die Steuerung getrennt zu der Auswertungseinrichtung 503 und Überwachungseinrichtung 504 implementiert sein. Zum Beispiel kann es sich bei der Steuerung 501 um eine Steuerung einer Elektronik handeln, in der das Relais eingebaut ist und die Erfassungseinrichtung 502, Auswertungseinrichtung 503 und Überwachungseinrichtung 504 werden an die Steuerung 501 angekoppelt, um das Relais zu überwachen bzw. Ausfallvorhersagen zum Relais zu treffen.

Die Steuerung 501 kann mit der Erfassungseinrichtung 502, der Auswertungseinrichtung 503 und der Überwachungseinrichtung 504 kommunikationstechnisch verbunden sein, um diese Einrichtungen zu steuern. Die Überwachungseinrichtung 500 kann während Labortests verwendet werden, um eine Aussage über die Ausfallwahrscheinlichkeit bestimmter Relaistypen zu treffen. Alternativ kann die Überwachungseinrichtung 500 auch im Feld eingesetzt werden und während des laufenden Betriebs des Relais den Verlauf der Kontaktspannung am Lastkontakt aufnehmen, um das Relais im Feld zu überwachen. Bei drohendem Ausfall kann ein Warnhinweis an das Servicepersonal gesendet werden, um einen Austausch zu veranlassen.

## Patentansprüche

1. Verfahren (200) zur Ausfallvorhersage eines Elementarrelais (100) mit einem Schalter (101) zum Schalten eines Lastkontaktes (102) eines Laststromkreises (103) und einer Erregerspule (104) zum Betätigen (105) des Schalters (101), wobei das Verfahren (200) die folgenden Schritte umfasst:
Erregen (201) der Erregerspule (104) zum Einschalten (105) des Lastkontaktes (102);
Erfassen (202) eines zeitlichen Verlaufs einer Kontaktspannung (107) an dem Lastkontakt (102) beim Einschalten (105) des Lastkontaktes (102);
Extrahieren (203) eines charakteristischen Merkmals aus dem zeitlichen Verlauf der Kontaktspannung (107); und
Überwachen (204) des charakteristischen Merkmals während eines Betriebs des Elementarrelais (100),
**dadurch gekennzeichnet, dass**
das charakteristische Merkmal ein Kontaktspannungsrauschen (300) an dem Lastkontakt (102) beim Einschaltvorgang (105) des Elementarrelais (100) umfasst.

2. Verfahren (200) nach Anspruch 1,
wobei das Extrahieren des Kontaktspannungsrauschens (300) ein Bestimmen einer Abweichung des erfassten Kontaktspannungsverlaufs (302) zu einer vorgegebenen Referenzkurve (301) umfasst.

3. Verfahren (200) nach Anspruch 2,
wobei die Referenzkurve (301) den zeitlichen Verlauf der Kontaktspannung (107) an dem Lastkontakt (103) eines neu hergestellten Elementarrelais (100) darstellt.

4. Verfahren (200) nach Anspruch 2 oder 3,
wobei die Referenzkurve (301) einen monoton fallenden Spannungsverlauf von einer Anfangsspannung (U1) zu einer Endspannung (U0) anzeigt.

5. Verfahren (200) nach einem der vorstehenden Ansprüche, mit:
Überwachen einer Amplitude des Kontaktspannungsrauschens (300) während des Betriebs des Elementarrelais (100).

6. Verfahren (200) nach einem der vorstehenden Ansprüche, mit:
Überwachen einer Rauschlänge (400) des Kontaktspannungsrauschens (300) über dem Lastkontakt (102) während des Betriebs des Elementarrelais (100).

7. Verfahren (200) nach einem der vorstehenden Ansprüche, mit:
Überwachen einer zeitlichen Veränderung des Kontaktspannungsrauschens (300) über dem Lastkontakt (102) bezüglich einer Anzahl von Schaltspielen des Elementarrelais (100).

8. Verfahren (200) nach einem der vorstehenden Ansprüche, mit:
Bestimmen einer Ausfallvorhersage des Elementarrelais (100) basierend auf einer über eine vorgegebene Anzahl von Schaltspielen gemittelten Rauschlänge.

9. Verfahren (200) nach Anspruch 8, mit:
Ausgeben eines Warnhinweises bei Überschreiten eines vorgegebenen Grenzwertes für die gemittelte Rauschlänge.

10. Vorrichtung (500) zur Überwachung eines Elementarrelais (100) mit einem Schalter (101) zum Schalten eines Lastkontaktes (102) eines Laststromkreises (103) und einer Erregerspule (104) zum Betätigen (105) des Schalters (101), wobei die Vorrichtung (500) folgendes umfasst:
eine Steuerung (501), die ausgebildet ist, die Erregerspule (104) zum Einschalten (105) des Lastkontaktes (102) zu erregen (505);
eine Erfassungseinrichtung (502) zum Erfassen (506) eines zeitlichen Verlaufs einer Kontaktspannung (107) an dem Lastkontakt (102) beim Einschalten (105) des Lastkontaktes (102) durch die Steuerung (501);
eine Auswertungseinrichtung (503) zum Extrahieren (507) eines charakteristischen Merkmals (510) aus dem zeitlichen Verlauf der Kontaktspannung (107); und
eine Überwachungseinrichtung (504) zum Überwachen (508) des charakteristischen Merkmals (510) während eines Betriebs des Elementarrelais (100),
**dadurch gekennzeichnet, dass**
das charakteristische Merkmal (510) ein Kontaktspannungsrauschen (300) an dem Lastkontakt (102) beim Einschaltvorgang (105) des Elementarrelais (100) umfasst.

11. Vorrichtung (500) nach Anspruch 10,
wobei die Erfassungseinrichtung (502) ausgebildet ist, den zeitlichen Verlauf der Kontaktspannung (107) an dem Lastkontakt (102) für eine Signaldauer von etwa 20 bis 50 ms nach dem Erregen (510) der Erregerspule (104) durch die Steuerung (501) aufzuzeichnen (506).

12. Vorrichtung (500) nach Anspruch 10 oder 11,
wobei die Auswertungseinrichtung (503) ausgebildet ist, eine Rauschlänge (400) des Kontaktspannungsrauschens (300) während des Betriebs des Elementarrelais (100) zu bestimmen.

13. Vorrichtung (500) nach einem der Ansprüche 10 bis 12,
wobei die Überwachungseinrichtung (504) ausgebildet ist, eine Ausfallvorhersage des Elementarrelais (100) basierend auf einer über eine vorgegebene Anzahl von Schaltspielen gemittelten Rauschlänge des Kontaktspannungsrauschens (300) zu ermitteln.

## Claims

1. Method (200) for predicting the failure of an elementary relay (100) having a switch (101) for switching a load contact (102) of a load circuit (103) and an excitation coil (104) for actuating (105) the switch (101), wherein the method (200) comprising the following steps:
Exciting (201) the excitation coil (104) in order to switch on (105) the load contact (102);
Detecting (202) a time characteristic of a contact voltage (107) at the load contact (102) when switching on (105) the load contact (102);
Extracting (203) a characteristic feature from the time characteristic of the contact voltage (107); and
Monitoring (204) the characteristic feature during operation of the elementary relay (100),
**characterized in that**
the characteristic feature comprises a contact voltage noise (300) at the load contact (102) during the switching-on process (105) of the elementary relay (100).

2. Method (200) according to claim 1,
wherein extracting the contact voltage noise (300) comprises determining a deviation of the detected contact voltage characteristic (302) from a predetermined reference curve (301).

3. Method (200) according to claim 2,
wherein the reference curve (301) represents the time characteristic of the contact voltage (107) at the load contact (103) of a newly manufactured elementary relay (100).

4. Method (200) according to claim 2 or 3,
wherein the reference curve (301) shows a monotonically falling voltage characteristic from an initial voltage (U1) to an end voltage (U0).

5. Method (200) according to any one of the preceding claims, comprising:
Monitoring an amplitude of the contact voltage noise (300) during operation of the elementary relay (100).

6. Method (200) according to any one of the preceding claims, comprising:
Monitoring a noise length (400) of the contact voltage noise (300) across the load contact (102) during operation of the elementary relay (100).

7. Method (200) according to any one of the preceding claims, comprising:
Monitoring a change over time in the contact voltage noise (300) across the load contact (102) with respect to a number of switching cycles of the elementary relay (100).

8. Method (200) according to any one of the preceding claims, comprising:
Determining a prediction of failure of the elementary relay (100) based on a noise length averaged over a predetermined number of switching cycles.

9. Method (200) according to claim 8, comprising:
Outputting a warning when a predetermined limit value for the averaged noise length is exceeded.

10. Device (500) for monitoring an elementary relay (100) having a switch (101) for switching a load contact (102) of a load circuit (103) and an excitation coil (104) for actuating (105) the switch (101), wherein the device (500) comprising the following:
a controller (501), which is adapted to excite (505) the excitation coil (104) for switching on (105) the load contact (102);
a detection device (502) for detecting (506) a time characteristic of a contact voltage (107) at the load contact (102) when switching on (105) the load contact (102) by the controller (501);
an evaluation device (503) for extracting (507) a characteristic feature (510) from the time characteristic of the contact voltage (107); and
a monitoring device (504) for monitoring (508) the characteristic feature (510) during operation of the elementary relay (100),
**characterized in that**
the characteristic feature (510) comprises a contact voltage noise (300) at the load contact (102) during the switching-on process (105) of the elementary relay (100).

11. Device (500) according to claim 10,
wherein the detection device (502) is adapted to record (506) the time characteristic of the contact voltage (107) at the load contact (102) for a signal duration of approximately 20 to 50 ms after the excitation (510) of the excitation coil (104) by the controller (501).

12. Device (500) according to claim 10 or 11,
wherein the evaluation device (503) is adapted to determine a noise length (400) of the contact voltage noise (300) during operation of the elementary relay (100).

13. Device (500) according to one of claims 10 to 12,
wherein the monitoring device (504) is adapted to determine a prediction of failure of the elementary relay (100) based on a noise length of the contact voltage noise (300) averaged over a predetermined number of switching cycles.

## Revendications

1. Procédé (200) de prédiction de défaillance d'un relais élémentaire (100) comprenant un commutateur (101) pour commuter un contact de charge (102) d'un circuit de charge (103) et une bobine d'excitation (104) pour actionner (105) le commutateur (101), le procédé (200) comprenant les étapes suivantes :
Excitation (201) de la bobine d'excitation (104) pour activer (105) le contact de charge (102) ;
Détection (202) d'une évolution dans le temps d'une tension de contact (107) aux bornes du contact de charge (102) lors de l'activation (105) du contact de charge (102) ;
Extraire (203) une caractéristique de l'évolution temporelle de la tension de contact (107) ; et
Surveiller (204) la caractéristique pendant un fonctionnement du relais élémentaire (100), **caractérisé en ce que**
la caractéristique comprend un bruit de tension de contact (300) au niveau du contact de charge (102) lors de l'activation (105) du relais élémentaire (100).

2. Procédé (200) selon la revendication 1,
dans lequel l'extraction du bruit de tension de contact (300) comprend une détermination d'un écart de la courbe de tension de contact (302) détectée par rapport à une courbe de référence (301) prédéterminée.

3. Procédé (200) selon la revendication 2,
dans lequel la courbe de référence (301) représente l'évolution dans le temps de la tension de contact (107) au niveau du contact de charge (103) d'un relais élémentaire (100) nouvellement fabriqué.

4. Procédé (200) selon la revendication 2 ou 3,
dans lequel la courbe de référence (301) indique une courbe de tension décroissante monotone d'une tension initiale (U1) à une tension finale (U0).

5. Procédé (200) selon l'une des revendications précédentes, comprenant :
Surveiller une amplitude du bruit de tension de contact (300) pendant le fonctionnement du relais élémentaire (100).

6. Procédé (200) selon l'une des revendications précédentes, comprenant :
Surveiller une longueur de bruit (400) du bruit de tension de contact (300) aux bornes du contact de charge (102) pendant le fonctionnement du relais élémentaire (100).

7. Procédé (200) selon l'une des revendications précédentes, comprenant :
Surveiller une variation temporelle du bruit de tension de contact (300) aux bornes du contact de charge (102) par rapport à un nombre de cycles de fonctionnement du relais élémentaire (100).

8. Procédé (200) selon l'une des revendications précédentes, comprenant :
Déterminer une prédiction de défaillance du relais élémentaire (100) sur la base d'une longueur de bruit moyennée sur un nombre prédéterminé de cycles de commutation.

9. Procédé (200) selon la revendication 8, comprenant :
Émission d'une alerte en cas de dépassement d'une valeur limite prédéfinie pour la longueur de bruit moyennée.

10. Dispositif (500) de surveillance d'un relais élémentaire (100) comprenant un commutateur (101) pour commuter un contact de charge (102) d'un circuit de charge (103) et une bobine d'excitation (104) pour actionner (105) le commutateur (101), le dispositif (500) comprenant :
une commande (501) qui est conçue pour exciter (505) la bobine d'excitation (104) afin d'activer (105) le contact de charge (102) ;
un dispositif de détection (502) pour détecter (506) une évolution dans le temps d'une tension de contact (107) aux bornes du contact de charge (102) lors de l'activation (105) du contact de charge (102) par la commande (501) ;
un dispositif d'évaluation (503) pour extraire (507) une caractéristique (510) de la courbe temporelle de la tension de contact (107) ; et
un dispositif de surveillance (504) pour surveiller (508) la caractéristique (510) pendant un fonctionnement du relais élémentaire (100),
**caractérisé en ce que**
la caractéristique (510) comprend un bruit de tension de contact (300) au niveau du contact de charge (102) lors de l'activation (105) du relais élémentaire (100).

11. Dispositif (500) selon la revendication 10,
dans lequel le dispositif de détection (502) est conçu pour enregistrer (506) l'évolution dans le temps de la tension de contact (107) aux bornes du contact de charge (102) pour une durée de signal d'environ 20 à 50 ms après l'excitation (510) de la bobine d'excitation (104) par la commande (501).

12. Dispositif (500) selon la revendication 10 ou 11,
dans lequel le dispositif d'évaluation (503) est conçu pour déterminer une longueur de bruit (400) du bruit de tension de contact (300) pendant le fonctionnement du relais élémentaire (100).

13. Dispositif (500) selon l'une des revendications 10 à 12,
dans lequel le dispositif de surveillance (504) est conçu pour déterminer une prédiction de défaillance du relais élémentaire (100) sur la base d'une longueur de bruit du bruit de tension de contact (300) moyennée sur un nombre prédéterminé de cycles de commutation.
